# EUROPÄISCHE PATENTSCHRIFT

(11) **EP 2 335 081 B1**
(45) Veröffentlichungstag und Bekanntmachung des Hinweises auf die Patenterteilung: **22.11.2017**
(21) Anmeldenummer: 09751770.0
(22) Anmeldetag: 05.10.2009
(51) Int. Cl.: G01R 1/067, H01L 21/768

(54) **VORRICHTUNG ZUR PLATZIERUNG UND KONTAKTIERUNG VON PRÜFKONTAKTEN**
DEVICE FOR POSITIONING AND CONTACTING TEST CONTACTS
DISPOSITIF DE PLACEMENT ET DE MISE EN CONTACT DE CONTACTS DE VÉRIFICATION

(30) Priorität: 17.10.2008 DE 102008051853
(43) Veröffentlichungstag der Anmeldung: 22.06.2011
(73) Patentinhaber: Pac Tech - Packaging Technologies GmbH, 14641 Nauen (DE)
(72) Erfinder: AZDASHT, Ghassem, 13591 Berlin (DE)
(74) Vertreter: advotec.
(86) Internationale Anmeldenummer: PCT/DE2009/001374
(87) Internationale Veröffentlichungsnummer: WO 2010/043196

(56) Entgegenhaltungen:
- WO-A-2007/100713
- WO-A-2008/036786
- DE-A1- 10 035 976
- DE-A1- 10 037 216
- JP-A- 2006 234 691
- US-A1- 2001 009 376
- US-A1- 2006 065 642
- US-A1- 2007 013 390
- US-A1- 2008 308 536

## Beschreibung

Die vorliegende Erfindung betrifft eine Vorrichtung zur Platzierung und Kontaktierung von Prüfkontakten auf einem Kontaktträger zur Herstellung einer Prüfkontaktanordnungnach Anspruch 1.

Prüfkontaktanordnungen mit einer Vielzahl von Prüfkontakten sind auf einer gemeinsamen Prüfplattform angeordnet, die mit einer Ansteuereinrichtung zur Ansteuerung der einzelnen Prüfkontakte versehen ist. Die Prüfkontakte befinden sich dabei in einer Matrixanordnung entsprechend den in einem Waferverbund angeordneten Chips, so dass über die einzelnen Prüfkontakte eine definierte Kontaktierung der einzelnen Chips auf Waferebene möglich ist.

Zur Herstellung einer Prüfkontaktanordnung werden die einzelnen Prüfkontakte entsprechend der gewünschten Matrixanordnung ihrer Kontaktspitzen auf einen als Prüfplatine ausgebildeten Kontaktträger angeordnet und mit auf der Prüfplatine ausgebildeten Kontaktflächen verlötet. Aufgrund der hohen Dichte der Prüfkontakte auf jeder Prüfplatine und dem sich daraus ergebenden, geringen Abstand der Prüfkontakte voneinander bestehen besonders hohe Anforderungen an eine sowohl elektrisch zuverlässige als auch positionsgenaue Kontaktierung der Prüfkontakte auf der Prüfplatine.

Aus der WO 2008/036786 ist eine Vorrichtung bekannt, die eine Prüfkontaktanordnung mit einer Prüfkontakthalteeinrichtung aufweist. Darüber hinaus weist die Vorrichtung eine an einem Kontaktkopf ausgebildete Heizeinrichtung auf.

Die DE 100 35 976 A1 zeigt eine Handhabungseinrichtung zur Positionierung von Prüfkontakten auf einem Kontaktträger.

Aus der US 2007/0013390 A1 ist ebenfalls eine Vorrichtung zur Platzierung von Prüfkontakten bekannt, bei der ein Kontaktkopf mit Prüfkontakthalteeinrichtung vorgesehen ist.

Der vorliegenden Erfindung liegt die Aufgabe zugrunde, eine Vorrichtung zur Platzierung und Kontaktierung von Prüfkontakten auf einem Kontaktträger vorzuschlagen, die eine positionsgenaue Platzierung und eine besonders zuverlässige Kontaktierung der Prüfkontakte auf einem Kontaktträger ermöglicht.

Zur Lösung dieser Aufgabe weist die erfindungsgemäße Vorrichtung die Merkmale des Anspruchs 1 auf.

Erfindungsgemäß weist die Vorrichtung zur Platzierung und Kontaktierung von Prüfkontakten auf einem Kontaktträger zur Herstellung einer Prüfkontaktanordnung einen zumindest einen Transmissionskanal zur Transmission von Wärmeenergie aufweisenden und mit einer Prüfkontakthaltereinrichtung versehenen Kontaktkopf auf, der an seinem Kontaktierungsende im Bereich einer Kanalmündung mit einer Prüfkontaktaufnahme versehen ist, wobei die Prüfkontaktaufnahme eine Positionierungseinrichtung mit zumindest zwei Positionierungsflächen zur positionierenden Anlage an einem Prüfkontakt und Positionierung des Prüfkontakts mit einem Absorptionsbereich zur Absorption der Wärmeenergie in der Kanalmündung aufweist.

Die erfindungsgemäße Vorrichtung ermöglicht somit nicht nur eine sichere Aufnahme und Handhabung des Prüfkontakts in der Prüfkontaktaufnahme während eines Handhabungs- und Platzierungsvorgangs. Vielmehr ermöglicht die erfindungsgemäße Vorrichtung vermittels einer in der Prüfkontaktaufnahme ausgebildeten Positionierungseinrichtung über zwei Positionierungsflächen eine exakte Positionierung des Prüfkontakts auf dem Kontaktträger bei gleichzeitig definierter Exponierung eines ausgewählten Absorptionsbereichs des Prüfkontakts in der Kanalmündung, derart, dass die Wärmeenergie diskret an einer gewünschten Stelle bzw. in einem gewünschten Bereich (Absorptionsbereich) des Prüfkontakts in diesen eingebracht werden kann, um sowohl den Ort der Energiebeaufschlagung als auch die Größe der Beaufschlagungsfläche an den zur Herstellung einer zuverlässigen Kontaktierung benötigten Energiebedarf anpassen zu können und eine verzugsfreie Anordnung des Prüfkontakts auf dem Kontaktträger zu ermöglichen.

Gemäß der Erfindung ist die Kanalmündung durch einen Austrittstrichter des Transmissionskanals gebildet und weist einen Öffnungsquerschnitt auf, der entsprechend dem Absorptionsquerschnitt des Absorptionsbereichs des Prüfkontakts bemessen ist. Durch eine entsprechende geometrische Gestaltung der Kanalmündung ist es mit relativ geringem technischen Aufwand möglich, für den Absorptionsbereich des Prüfkontakts eine definierte Oberfläche des Prüfkontakts vorzugeben.

Wenn gemäß einer bevorzugten Ausführungsform zumindest eine Positionierungsfläche der Positionierungseinrichtung oberhalb des Öffnungsquerschnitts der Kanalmündung angeordnet ist, derart, dass der Absorptionsbereich des Prüfkontakts innerhalb des Austrittstrichters der Kanalmündung angeordnet ist, kann auf einfache Art und Weise eine relativ große Teiloberfläche des Prüfkontakts mit Wärmeenergie beaufschlagt werden.

Besonders vorteilhaft ist es auch, wenn die Kanalmündung einen unter einem Neigungswinkel zur Längsachse des Kontaktkopfs angeordneten Öffnungsquerschnitt aufweist, wobei eine Positionierungsfläche durch einen den Öffnungsquerschnitt begrenzenden Öffnungsrand der Kanalmündung gebildet ist. Hierdurch wird eine gezielte seitliche Beaufschlagung einer Teiloberfläche des Prüfkontakts möglich, wobei gleichzeitig eine entsprechend seitliche Erstreckung des Kontaktkopfs zum Prüfkontakt bei Anordnung des Prüfkontakts auf dem Kontaktträger möglich ist. Insbesondere wird während der Platzierung und Köntaktierung eines Prüfkontakts auf einem Kontaktträger eine Schrägstellung des Kontaktkopfs zum Prüfkontakt möglich, wodurch eine Anordnung der Prüfkontakte auf dem Kontaktträger mit einem Abstand voneinander möglich wird, der kleiner ist als der Durchmesser des Kontaktkopfs.

Eine besonders optimale Relativanordnung des Prüfkontakts zum Kontaktkopf ergibt sich, wenn der Öffnungsquerschnitt derart im Bereich der Kanalmündung angeordnet ist, dass er parallel oder unter einem spitzen Winkel zur angrenzenden Außenwand des Kontaktkopfs angeordnet ist. Hierdurch kann einerseits sichergestellt werden, dass in Richtung einer bereits auf dem Kontaktträger angeordneten Sequenz von Prüfkontakten kein wesentlicher seitlicher Überstand des Kontaktkopfs über den Prüfkontakt einen möglichst geringen Kontaktabstand behindert. Zum anderen kann immer noch ein ausreichender Abstand zwischen dem schräg gestellten Kontaktkopf und dem Kontaktträger realisiert werden, um einen unerwünschten Kontakt zwischen dem Kontaktkopf und dem Kontaktträger zu verhindern.

Zur möglichst weitestgehenden Minimierung des Abstands zwischen Prüfkontakten auf dem Kontaktträger trägt darüber hinaus eine Abflachung der an den Öffnungsquerschnitt angrenzenden Außenwand des Werkzeugkörpers bei.

Vorteilhafte Beispiele werden nachfolgend anhand der Zeichnung näher erläutert.

Es zeigen:
- **Fig. 1**: einen Kontaktkopf einer Kontaktierungsvorrichtung;
- **Fig. 2**: den in **Fig. 1** dargestellten Kontaktkopf in einer Längsschnittdarstellung;
- **Fig. 3**: den in **Fig. 1** dargestellten Kontaktkopf mit einem in einer Prüfkontaktaufnahme eingesetzten Prüfkontakt;
- **Fig. 4**: einen Kontaktkopf einer Kontaktierungsvorrichtung in einer Ausführungsform;
- **Fig. 5**: den in **Fig. 4** dargestellten Kontaktkopf in einer Längsschnittdarstellung;
- **Fig. 6**: den in **Fig. 4** dargestellten Kontaktkopf mit einem in einer Prüfkontaktaufnahme angeordneten Prüfkontakt;
- **Fig. 7**: einen Kontaktkopf einer Kontaktierungsvorrichtung in einer weiteren Ausführungsform;
- **Fig. 8**: den in **Fig. 7** dargestellten Kontaktkopf in einer Längsschnittdarstellung;
- **Fig. 9**: den in **Fig. 7** dargestellten Kontaktkopf mit einem in einer Prüfkontaktaufnahme aufgenommenen Prüfkontakt;
- **Fig. 10**: einen Kontaktkopf während der Kontaktierung eines Prüfkontakts auf einem Kontaktträger;
- **Fig. 11**: den in den **Fig. 4 bis 6** dargestellten Kontaktkopf während der Kontaktierung eines Prüfkontakts auf einem Kontaktträger in perspektivischer Darstellung.

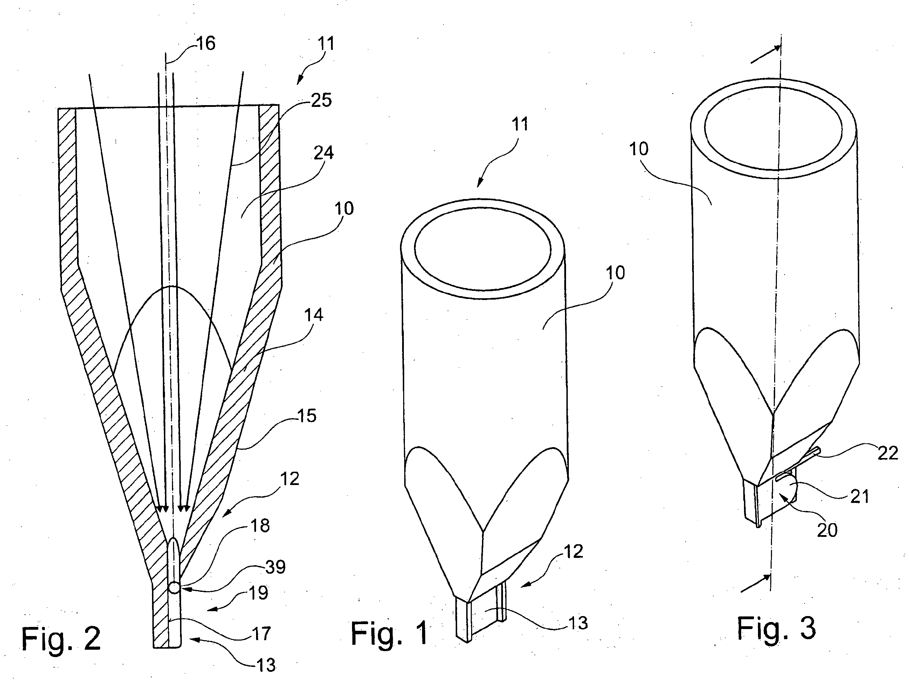

**Fig. 1** zeigt einen Kontaktkopf 10 einer Kontaktierungsvorrichtung 11 mit einer an einem Kontaktierungsende 12 ausgebildeten Prüfkontaktaufnahme 13. Wie aus der Längsschnittdarstellung gemäß **Fig. 2** deutlich wird, ist am Kontaktkopf 10 zum Kontaktende 12 hin ein Austrittstrichter 14 ausgebildet, der im Übergang zur Prüfkontaktaufnahme 13 eine Kanalmündung 39 mit einem Öffnungsquerschnitt 15 aufweist. Unterhalb des Öffnungsquerschnitts 15 erstreckt sich die hier im Querschnitt etwa U-förmig ausgebildete Prüfkontaktaufnahme 13, in der eine parallel zu einer Längsachse 16 des Kontaktkopfs 10 angeordnete Prüfkontaktbasisanlagefläche 17 eine erste Positionierungsfläche einer Positionierungseinrichtung 19 bildet.

Wie aus einer Zusammenschau der **Fig. 2 und 3** deutlich wird, ermöglicht die Prüfkontaktaufnahme 13 mit der darin ausgebildeten Positionierungseinrichtung 19 eine positionierende Aufnahme eines Prüfkontakts 20 derart, dass der Prüfkontakt 20 mit einer Prüfkontaktbasis 21 seitlich gegen die Prüfkontaktbasisanlagefläche 17 und mit einem an der Prüfkontaktbasis 21 angeordneten Prüfkontaktausleger 22 an einer als zweite Positionierungsfläche im Bereich der Kanalmündung 39 ausgebildeten Prüfkontaktauslegeranlagefläche 18 anliegt.

Wie insbesondere aus **Fig. 2** hervorgeht, ist durch Anordnung des Prüfkontakts 20 in der Prüfkontaktaufnahme 13 relativ zum Öffnungsquerschnitt 15 ein Absorptionsbereich als Teiloberfläche des Prüfkontakts 20 bzw. hier des Prüfkontaktauslegers 22 definiert, in dem eine Wärmeenergiebeaufschlagung des Prüfkontakts 20 mittels einer durch einen Transmissionskanal 24 im Inneren des Kontaktkopfs 10 bzw. des Austrittstrichters 14 geleiteten Laserstrahlung 25 erfolgt. Im Fall des vorliegend dargestellten Ausführungsbeispiels dient der Transmissionskanal 24 gleichzeitig zur Beaufschlagung des Prüfkontakts 20 bzw. des Absorptionsbereichs mit Unterdruck, um den Kontaktkopf 10 bzw. die Prüfkontaktaufnahme 13 gleichzeitig als Prüfkontakthaltereinrichtung auszubilden.

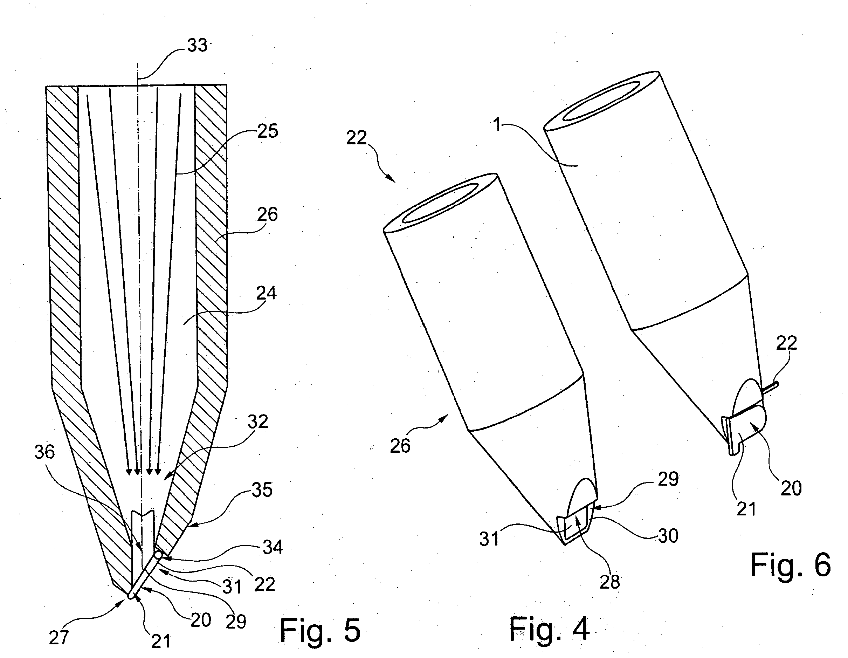

**Fig. 4** zeigt einen Kontaktkopf 26 der an einem Kontaktierungsende mit einer Prüfkontaktaufnahme 28 versehen ist, welche im Bereich einer Kanalmündung 27 eine Prüfkontaktbasisanlagefläche 29 aufweist, die durch einen Öffnungsrand 30 eines Öffnungsquerschnitts 31 gebildet ist.

Wie eine Zusammenschau der **Fig. 5 und 6** zeigt, ist der Öffnungsquerschnitt 31 eines im Kontaktkopf 26 ausgebildeten Austrittstrichters 32 unter einem Neigungswinkel α schräg zu einer Längsachse 33 des Kontaktkopfs 26 angestellt. Entsprechend schräg ist auch die Prüfkontaktbasisanlagefläche 29 zur Längsachse 33 angestellt, wobei eine Prüfkontaktauslegeranlagefläche 34 durch einen Unterrand einer Außenwand 35 des Kontaktkopfs 26 gebildet ist. Wie aus der strichpunktierten Darstellung des Prüfkontakts 20 in der Prüfkontaktaufnahme 28 in **Fig. 5** deutlich wird, ergibt sich aufgrund der relativ zur Längsachse 33 geneigten Anordnung der Prüfkontaktbasisanlagefläche 29 ein im Vergleich zu dem in den **Fig. 1 bis 3** dargestellten Ausführungsbeispiel eines Kontaktkopfs 10 wesentlich vergrößerter Absorptionsbereich 36 des Prüfkontakts 20, wobei hier im Wesentlichen eine seitliche Beaufschlagung der Prüfkontaktbasis 21 mit Laserstrahlung 25 erfolgt und der Prüfkontaktausleger 22 im Wesentlichen unbeaufschlagt bleibt. Hierdurch kann trotz einer im Wesentlichen großflächigen Laserbeaufschlagung der Prüfkontaktbasis 21, die einen ausreichenden Wärmeeintrag in den Prüfkontakt 20 ermöglicht, eine zum Verzug führende übermäßige Überhitzung des mit einem relativ dünnen Querschnitt versehenen Prüfkontaktauslegers 22 verhindert werden.

Wie ferner insbesondere aus **Fig. 5** deutlich wird, ist der Öffnungsquerschnitt 31 im Wesentlichen parallel mit der angrenzenden Außenwand 35 angeordnet, so dass im Vergleich zu dem in den **Fig. 1 bis 3** dargestellten Ausführungsbeispiel des Kontaktkopfs 10 der Prüfkontakt im Wesentlichen flächenbündig mit der Außenwand 35 angeordnet ist.

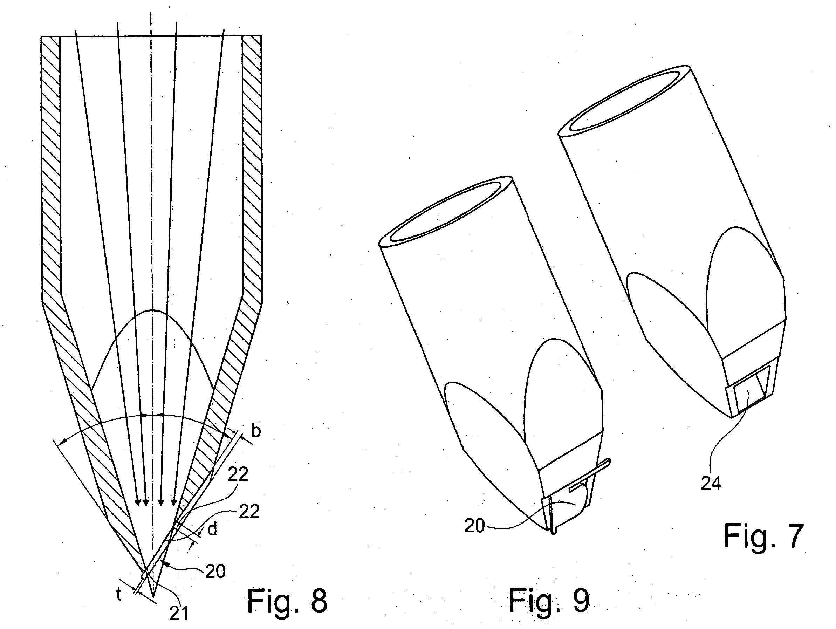

In den **Fig. 7 bis 9** ist in einer weiteren Ausführungsform ein Kontaktkopf dargestellt, der im Unterschied zu dem in den **Fig. 4 bis 6** dargestellten Kontaktkopf 26 eine Außenwand eines Austrittstrichters aufweist, die im Bereich einer Abflachung einen Unterrand aufweist, der eine Prüfkontaktauslegeranlagefläche bildet und eine Breite b aufweist, die im Wesentlichen dem Durchmesser d des Prüfkontaktauslegers 22 bzw. der Dicke t der Prüfkontaktbasis 21 entspricht. Hieraus resultiert, wie insbesondere aus **Fig. 9** ersichtlich, eine Anordnung des Prüfkontakts 20 in einer Prüfkontaktaufnahme des Kontaktkopfs, derart, dass der Prüfkontakt 20 im Wesentlichen bündig in der Außenwand angeordnet ist.

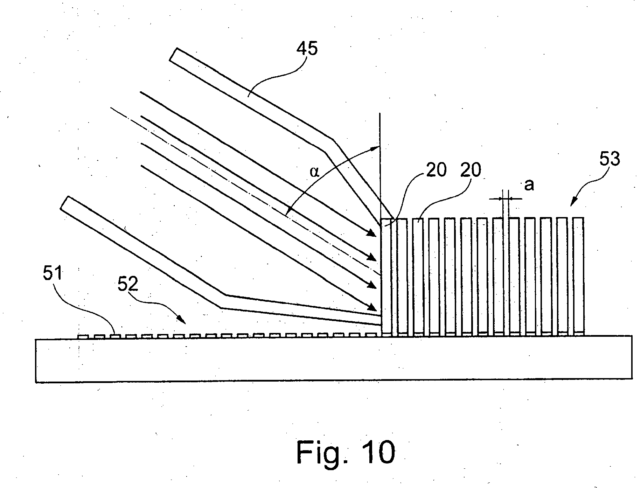

**Fig. 10** zeigt in schematischer Darstellung einen Kontaktkopf 45 während der Kontaktierung eines Prüfkontakts 20 auf einer auf einem Kontaktträger angeordneten Kontaktfläche 51. Wie **Fig. 10** ferner zeigt, bildet die Kontaktfläche 51 zusammen mit einer Vielzahl von weiteren Kontaktflächen 51 eine Kontaktflächenanordnung 52, die zur Kontaktierung bzw. Anordnung einer entsprechenden Anzahl von Prüfkontakten 20 zur Herstellung einer Prüfkontaktanordnung 53 dient.

Wie aus **Fig. 10** deutlich wird, wird die Prüfkontaktanordnung 53 durch sequentielle Kontaktierung der Prüfkontakte 20 beginnend mit dem in **Fig. 10** ganz rechts dargestellten Prüfkontakt 20 durchgeführt. Aufgrund der unter einem Neigungswinkel α zur Längsachse des Kontaktkopfs geneigten Anordnung der Prüfkontakte 20 ergibt sich eine im Wesentlichen seitlich schräge Anordnung des Kontaktkopfs 45 zum Prüfkontakt 20, so dass geringstmögliche Abstände a zwischen den einzelnen Prüfkontakten auf dem Kontaktträger möglich sind.

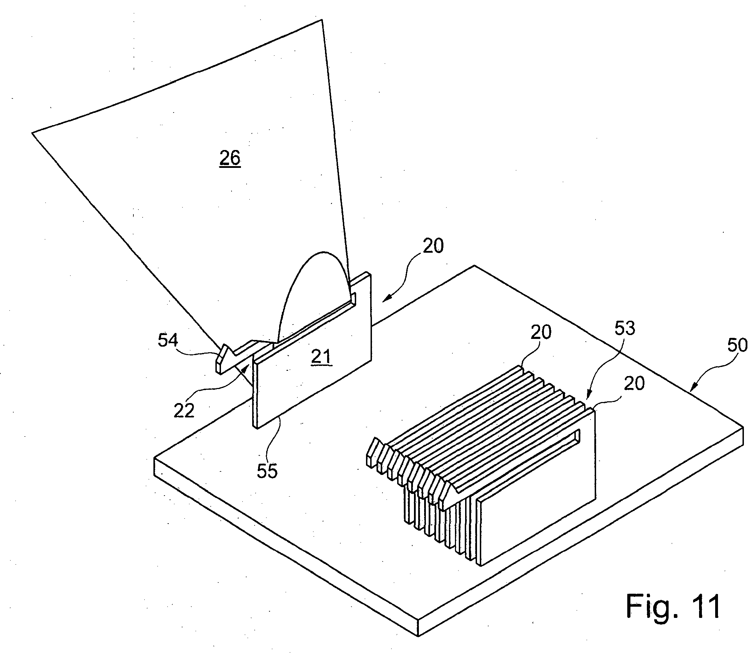

**Fig. 11** zeigt den in den **Fig. 4 bis 6** dargestellten Kontaktkopf 26 bei der Platzierung eines Prüfkontakts 20 auf dem Kontaktträger 50. Der in der Prüfkontaktaufnahme 28 während der Platzierung und der nachfolgenden Kontaktierung aufgenommene Prüfkontakt 20 liegt dabei mit seinem Prüfkontaktausleger 22 an der Prüfkontaktauslegeranlagefläche 34 an. Der Prüfkontaktausleger 22 erstreckt sich parallel zu einer hier im Wesentlichen rechteckförmig ausgebildeten Prüfkontaktbasis 21 und überragt mit seiner Prüfkontaktspitze 54 eine Unterkante 55 der Prüfkontaktbasis 21 längs der nachfolgend der Platzierung die Kontaktierung mit dem Kontaktträger 50 erfolgt.

## Patentansprüche

1. Vorrichtung zur Platzierung und Kontaktierung von Prüfkontakten (20) auf einem Kontaktträger (50) zur Herstellung einer Prüfkontaktanordnung (53) mit einem Kontaktkopf (26, 45), der eine Prüfkontakthalteeinrichtung und zumindest einen Transmissionskanal (24) zur Transmission von Wärmeenergie aufweist, wobei der Kontaktkopf (26, 45) an seinem Kontaktierungsende (12) im Bereich einer Kanalmündung (27, 39) mit einer Prüfkontaktaufnahme (13, 28) versehen ist, wobei die Prüfkontaktaufnahme eine Positionierungseinrichtung (19) mit zumindest einer ersten Positionierungsfläche (29) und einer zweiten Positionierungsfläche (34) zur positionierenden Anlage an einem Prüfkontakt und Positionierung des Prüfkontakts mit einem Absorptionsbereich zur Absorption der Wärmeenergie in der Kanalmündung aufweist,
wobei,
die Kanalmündung (27, 39) durch einen Austrittstrichter (32) des Transmissionskanals (24) gebildet ist und einen Öffnungsquerschnitt (31) aufweist, der entsprechend dem Absorptionsquerschnitt des Absorptionsbereichs des Prüfkontakts (20) bemessen ist, wobei der Öffnungsquerschnitt (31) unter einem Neigungswinkel α zu einer Längsachse (33) des Kontaktkopfsangeordnet ist, wobei die erste Positionierungsfläche (29) durch einen den Öffnungsquerschnitt (31) begrenzenden Öffnungsrand (30) der Kanalmündung (27, 39) gebildet ist, die zweite Positionierungsfläche (34) durch einen Unterrand einer Außenwand (35) des Kontaktkopfs gebildet ist und der Öffnungsquerschnitt (31) derart im Bereich der Kanalmündung (27, 39) angeordnet ist, dass er parallel zu dieser angrenzenden Außenwand (35) des Kontaktkopfs (26, 45) angeordnet ist.

2. Vorrichtung nach Anspruch 1,
**dadurch gekennzeichnet,**
**dass** zumindest eine Positionierungsfläche der Positionierungseinrichtung oberhalb des Öffnungsquerschnitts der Kanalmündung angeordnet ist, derart, dass der Absorptionsbereich des Prüfkontakts innerhalb des Austrittstrichters der Kanalmündung angeordnet ist.

3. Vorrichtung nach Anspruch 1,
**dadurch gekennzeichnet,**
**dass** die an den Öffnungsquerschnitt (31) angrenzende Außenwand des Kontaktkopfs eine Abflachung aufweist.

## Claims

1. A device for positioning and contacting test contacts (20) on a contact carrier (50) for producing a test contact arrangement (53) comprising a contact head (26, 45) having a test contact holding device and at least one transmission channel (24) for transmitting thermal energy, said contact head (26, 45) being equipped with a test contact receptacle (13, 28) on the contact end (12) thereof and in the region of a channel mouth (27, 39), wherein said test contact receptacle (13, 28) comprises a positioning device (19) having at least a first positioning face (29) and at least a second positioning face (34) for the positioning abutment against a test contact and positioning of an absorption region of the test contact in the channel mouth, said absorption region serving to absorb the thermal energy, wherein
the channel mouth (27, 39) is formed by an outlet funnel (32) of the transmission channel (24) and exhibits an opening cross-section (31) which is dimensioned in accordance with the absorption cross-section of the absorption region of the test contact (20), wherein the opening cross section (31) is arranged at an inclined angle α with respect to a longitudinal axis (33) of the contact head, wherein the first positioning face (29) is formed by an opening edge (30) of the channel mouth (27, 39), which limits the opening cross-section (31), the second positioning face (34) is formed by a lower edge of an outer wall (35) of the contact head and the opening cross-section (31) is disposed in the region of the channel mouth (27, 39) such that it is arranged in parallel to said adjacent outer wall (35) of the contact head (26, 45).

2. The device according to claim 1,
**characterized in that**
at least one positioning face of the positioning device is disposed above the opening cross-section of the channel mouth such that the absorption region of the test contact is arranged within the outlet funnel of the channel mouth.

3. The device according to claim 1,
**characterized in that**
the outer wall of the contact head which lies adjacent to the opening cross-section (31) exhibits a flat portion.

## Revendications

1. Dispositif de placement et de mise en contact de contacts de vérification (20) sur un porteur de contact (50) afin de produire un agencement (53) de contacts de vérification comprenant une tête de contact (26, 45) ayant un dispositif de support de contact de vérification et au moins un canal de transmission (24) pour la transmission d'énergie thermique, ladite tête de contact (26, 45) étant munie d'un logement (13, 28) de contact de vérification sur son extrémité (12) de mise en contact dans la région d'une embouchure de canal (27, 39), ledit logement (13, 28) de contact de vérification comprenant un dispositif de positionnement (19) ayant au moins une première face de positionnement (29) et au moins une deuxième face de positionnement (34) destinées à venir en contact positionnant avec un contact de vérification et à positionner une région d'absorption du contact de vérification dans l'embouchure de canal, ladite région d'absorption servant à absorber l'énergie thermique,
dans lequel
l'embouchure de canal (27, 39) est formée par un entonnoir de sortie (32) du canal de transmission (24) et présente une section transversale d'ouverture (31) qui a des dimensions correspondant à la section transversale d'absorption de la région d'absorption du contact de vérification (20), la section transversale d'ouverture (31) étant disposée à un angle d'inclinaison α par rapport à un axe longitudinal (33) de la tête de contact, la première face de positionnement (29) étant formée par un bord d'ouverture (30) de l'embouchure de canal (27, 39), qui délimite la section transversale d'ouverture (31), la deuxième face de positionnement (34) étant formée par un bord inférieur d'une paroi extérieure (35) de la tête de contact et la section transversale d'ouverture (31) étant disposée dans la région de l'embouchure de canal (27, 39) de telle manière qu'elle est disposée parallèle à ladite paroi extérieure (35) adjacente de la tête de contact (26, 45).

2. Dispositif selon la revendication 1,
**caractérisé en ce qu'**
au moins une face de positionnement du dispositif de positionnement est disposée au-dessus de la section transversale d'ouverture de l'embouchure de canal de telle manière que la région d'absorption du contact de vérification est disposée dans l'entonnoir de sortie de l'embouchure de canal.

3. Dispositif selon la revendication 1,
**caractérisé en ce que**
la paroi extérieure de la tête de contact adjacente à la section transversale d'ouverture (31) présente une partie plate.
